# EUROPÄISCHE PATENTSCHRIFT

(11) **EP 1 511 368 B1**
(45) Veröffentlichungstag und Bekanntmachung des Hinweises auf die Patenterteilung: **20.05.2015**
(21) Anmeldenummer: 04019468.0
(22) Anmeldetag: 17.08.2004
(51) Int. Cl.: B60R 16/02, H05K 5/00, H05K 7/14

(54) **Sandwich Gehäuse für einen Antennenverstärker**
Sandwich housing for antenna amplifier
Boîtier-sandwich pour un amplificateur d' antenne

(30) Priorität: 29.08.2003 DE 10340257; 06.03.2004 DE 102004011032
(43) Veröffentlichungstag der Anmeldung: 02.03.2005
(73) Patentinhaber: Hirschmann Car Communication GmbH, 72654 Neckartenzlingen (DE)
(72) Erfinder: Zoller, Ortwin, 71155 Altdorf (DE)
(74) Vertreter: Greif, Thomas

(56) Entgegenhaltungen:
- DE-A- 4 218 112
- DE-A- 19 506 664
- DE-A- 19 803 358
- US-A- 5 418 685
- PATENT ABSTRACTS OF JAPAN Bd. 1999, Nr. 14, 22. Dezember 1999 (1999-12-22) & JP 11 261254 A (JAPAN AVIATION ELECTRONICS IND LTD; DENSO CORP), 24. September 1999 (1999-09-24)

## Beschreibung

Die Erfindung betrifft ein Gehäuse für ein Elektronikgerät, insbesondere einen Antennenverstärker eines Fahrzeuges, wobei das Gehäuse zumindest eine Leiterplatte insbesondere mit elektronischen Bauteilen und insbesondere mit wenigstens einer Steckverbindung aufnimmt und aus zumindest zwei Gehäuseteilen besteht, gemäß den Merkmalen des Oberbegriffes des Patentanspruches 1.

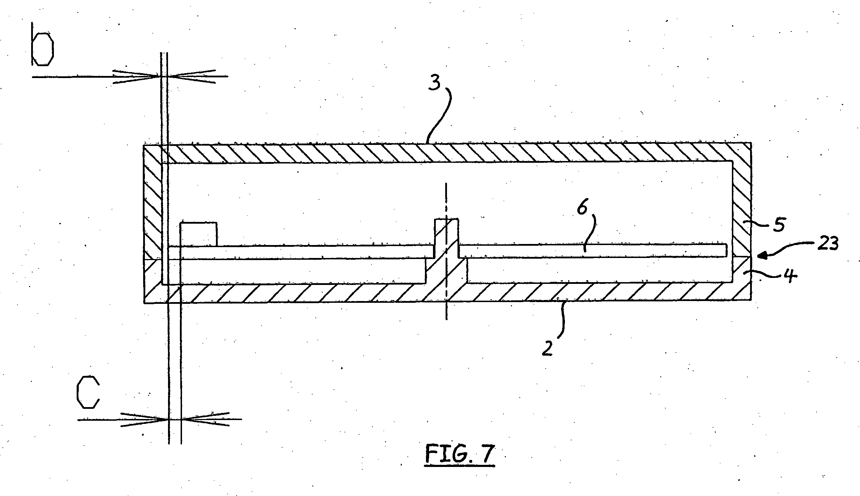

Bisher bekannte Gehäuse für solche elektronischen Geräte bestehen aus zumindest zwei Gehäuseteilen, im Regelfall einem Unterteil und einem Oberteil. Das Unterteil ist dabei als flächige Platte mit einem umlaufenden Rand ausgebildet. Innerhalb des umlaufenden Randes kann eine Schaltungsplatine (Leiterplatte), die elektronische Bauteile sowie Steckverbindungen und dergleichen aufweisen kann, in dem Unterteil angeordnet werden. Dabei kann entweder der umlaufende Rand zur Lagefixierung der Leiterplatte in dem Unterteil dienen oder alternativ oder ergänzend dazu können auch Mittel (wie z.B. Zapfen) an dem Unterteil des Gehäuses vorhanden sein, die die Lagefixierung der Schaltungsplatine übernehmen. Diese Zapfen beispielsweise greifen in korrespondierende Bohrungen in der Schaltungsplatine ein. Nachdem die Schaltungsplatine in dem Unterteil des Gehäuses festgelegt worden ist, erfolgt das Verschließen des Gehäuses durch ein Oberteil, das ebenfalls aus einer flächigen Platte mit umlaufendem Rand besteht, wobei die Ränder des Unterteiles und die Ränder des Oberteiles miteinander korrespondieren und nach dem Zusammensetzen in Anlage kommen. Dieser Aufbau des Elektronikgerätes hat jedoch den Nachteil, dass zwischen dem Rand der Leiterplatte und dem Gehäuserand ein Abstand vorgesehen werden muss, da diese toleranzbehaftet sind und somit der Zwischenraum zwischen dem Rand der Leiterplatte und dem Gehäuse als Toleranzausgleich dient. Außerdem kann in einem solchen Fall der Rand der Leiterplatte nicht zur Befestigung herangezogen werden, so dass die Leiterplatte z.B. durch Verschrauben, Vernieten, Verstemmen oder Verklipsen in oder an dem Gehäuse befestigt werden muss. Diese Befestigungstechniken sind jedoch meistens aufwändig und kostenintensiv, da sie Zusatzteile (wie beispielsweise Schrauben, Nieten und dergleichen) ebenso wie Montagewerkzeuge und/oder Montagevorrichtungen erfordern und höhere Anforderungen an die Genauigkeit der Geometrien der zu verbindenden Teile stellen (insbesondere in Bezug auf Ebenheit, Positions- und Formgenauigkeit). Ein beispielhafter Aufbau eines Gehäuses nach dem Stand der Technik ist in Figur 7 im Schnitt dargestellt.

Die US 5,418,685 A offenbart ein Gehäuse für ein Elektronikgerät, wobei das Gehäuse zumindest eine Leiterplatte mit elektronischen Bauteilen aufnimmt und aus zumindest zwei Gehäuseteilen wie einem Unterteil und einem Oberteil besteht, wobei Mittel zum Verbinden der zumindest beiden Gehäuseteile miteinander vorhanden sind, wobei durch das Verbinden die Leiterplatte in Teilbereichen von den beiden Gehäuseteilen eingeklemmt und dadurch in ihrer Lage in dem Gehäuse fixiert wird, wobei die äußeren Randbereiche der Leiterplatte zwischen den einander zugewandten Flächen der umlaufenden Ränder der Gehäuseteile eingeklemmt sind und wobei das zumindest eine elektronische Bauteil sehr nah bis an den umlaufenden Rand eingeordnet ist, so dass der Abstand "a" zwischen diesem elektronischen Bauteil und dem umlaufenden Rand kleingehalten werden kann.

Die DE 195 06 664 A offenbart ein Gehäuse für ein Elektronikgerät, wobei das Gehäuse zumindest eine Leiterplatte mit elektronischen Bauteilen aufnimmt und aus zumindest zwei Gehäuseteilen wie einem Unterteil und einem Oberteil besteht, wobei Mittel zum Verbinden der zumindest beiden Gehäuseteile miteinander vorhanden sind, wobei durch das Verbinden die Leiterplatte in Teilbereichen von den beiden Gehäuseteilen eingeklemmt und dadurch in ihrer Lage in dem Gehäuse fixiert wird, wobei die äußeren Randbereiche der Leiterplatte zwischen den einander zugewandten Flächen umlaufenden Ränder der Gehäuseteile eingeklemmt sind und das zumindest eine elektronische Bauteil sehr nah bis an den umlaufenden Rand angeordnet ist, so dass der Abstand "a" zwischen diesem elektronischen Bauteil und dem umlaufenden Rand kleingehalten werden kann.

Die US 2001/028555 A1 offenbart ein Gehäuse für ein Elektronikgerät, wobei das Gehäuse zumindest eine Leiterplatte mit elektronischen Bauteilen aufnimmt und aus zumindest zwei Gehäuseteilen wie einem Unterteil und einem Oberteil besteht, wobei Mittel zum Verbinden der zumindest beiden Gehäuseteile miteinander vorhanden sind, wobei durch das Verbinden die Leiterplatte in Teilbereichen von den beiden Gehäuseteilen eingeklemmt und dadurch in ihrer Lage in dem Gehäuse fixiert wird, wobei die äußeren Randbereiche der Leiterplatte zwischen den einander zugewandten Flächen der umlaufenden Ränder der Gehäuseteile eingeklemmt sind und das zumindest eine elektronische Bauteil sehr nah bis an den umlaufenden Rand angeordnet ist, so dass der Abstand "a" zwischen diesem elektronischem Bauteil und dem umlaufenden Rand kleingehalten werden kann.

Der Erfindung liegt daher die Aufgabe zu Grunde, zumindest eine Leiterplatte in einem Gehäuse für ein Elektronikgerät bereitzustellen, die keine zusätzlichen Montageaufwand benötigt und ein möglichst optimales Verhältnis zwischen der effektiv für die elektronischen Bauteile zur Verfügung stehenden Leiterplattenfläche und den Gehäuseabmessungen bietet.

Diese Aufgabe ist durch die Merkmale des Patentanspruches 1 gelöst.

Erfindungsgemäß sind Mittel zum Verbinden der beiden Gehäuseteile miteinander vorhanden, wobei durch das Verbinden die Leiterplatte in Teilbereichen von den beiden Gehäuseteilen eingeklemmt und dadurch in ihrer Lage in dem Gehäuse fixiert wird. Durch den Einklemmvorgang werden zunächst zusätzliche Befestigungselemente für die Leiterplatte an dem Gehäuse vermieden. Ergänzend dazu wird die Leiterplatte in ihrer Lage in dem Gehäuse fixiert, indem die zumindest beiden Gehäuseteile miteinander verbunden werden, wobei durch diese Verbindung sichergestellt wird, dass Teilbereiche der Leiterplatte (wie insbesondere umlaufende Randbereiche) von zugehörigen Bereichen der Gehäuseteile eingeklemmt und damit in ihrer Lage fixiert werden. Das bedeutet, dass durch das Zusammenbringen der zumindest beiden Gehäuseteile die Leiterplatte im selben Moment ebenfalls befestigt und in ihrer Lage fixiert wird, indem sie zwischen die beiden Gehäuseteile eingeklemmt wird und damit eine feste Einheit mit den Gehäuseteilen bildet. In besonders vorteilhafter Weise erfolgt das Einklemmen der Leiterplatte zwischen den zumindest beiden Gehäuseteilen unter Einlegen einer Dichtung oder Aufbringen von Dichtmaterial auf die Leiterplatte bzw. die Bereiche der Gehäuseteile, an denen die Klemmung erfolgt, so dass mit einem einzigen Montageschritt ein gegenüber äußeren Umwelteinflüssen dichtend abgeschlossenes Gehäuse für eine Elektronikgerät entsteht.

In Weiterbildung der Erfindung sind die Mittel zum Verbinden der zumindest beiden Gehäuseteile miteinander als Rastmittel ausgebildet. Dies hat den Vorteil, dass durch die Rastmittel ein einfaches Verklipsen der zumindest beiden Gehäuseteile miteinander erfolgen kann, wodurch die Montagefreundlichkeit weiter erhöht wird. In besonders vorteilhafter Weise steht die Rastverbindung nach dem Verbinden unter einer Vorspannung, so dass von beiden Seiten der Gehäuseteile Druck auf die eingeklemmten Bereiche der Leiterplatte ausgeübt wird und sich dadurch eine stabile Einheit aus Gehäuse und Leiterplatte ergibt. Dies ist besonders wichtig bei der Anwendung des Gehäuses für das Elektronikgerät im Bereich der Fahrzeugtechnik, wo z.B. ein Antennenverstärker in dem Gehäuse angeordnet ist, der in einem Scheibenbereich des Fahrzeuges befestigt wird. Würde sich hier beim bekannten Stand der Technik die Leiterplatte in dem Gehäuse bewegen können, käme es zu unerwünschten Geräuschen, die mit dem Einklemmen der Leiterplatte zwischen den zumindest beiden Gehäuseteilen wirksam vermieden wird.

Ausführungsbeispiele der Erfindung, auf die diese jedoch nicht beschränkt ist, sind im Folgenden beschrieben und anhand der Figuren erläutert.

Es zeigen:
- Figur 1:: Einen Schnitt durch ein Elektronikgerät in Sandwichbauweise,
- Figur 2:: Ein Unterteil des Gehäuses vor der Aufnahme der Leiterplatte,
- Figur 3:: Eine bestückte Leiterplatte vor der Montage in das Unterteil,
- Figur 4:: Die Leiterplatte gemäß Figur 3, die in das Unterteil eingelegt ist,
- Figur 5:: Das fertig montierte Elektronikgerät
- Figur 6:: Montagereihenfolge bei einer anderen Ausgestaltung der Gehäuseteile
- Figur 7:: Schnitt durch ein Elektronikgerät gemäß dem Stand der Technik.

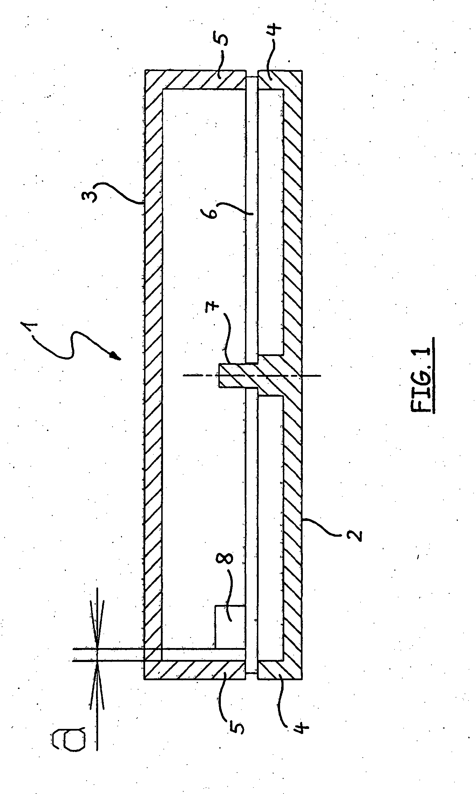

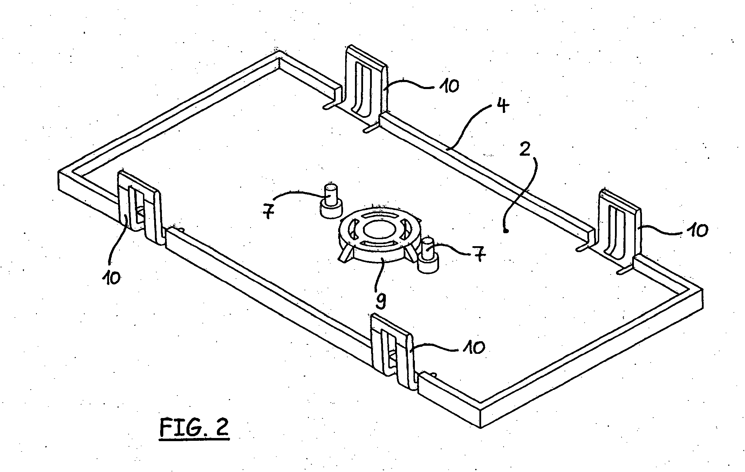

Figur 1 zeigt einen Schnitt durch ein Elektronikgerät, insbesondere einen Antennenverstärker eines Fahrzeuges, wobei das Elektronikgerät ein Gehäuse 1 aufweist. In diesem Ausführungsbeispiel ist das Gehäuse 1 gebildet durch (zumindest) ein Unterteil 2 sowie (zumindest) ein Oberteil 3. Diese beiden Teile 2 und 3 haben eine flächige Gestalt und sind mit einem zumindest teilweise umlaufenden Rand 4 bzw. 5 versehen. Die Höhe der beiden umlaufenden Ränder, 4, 5 richtet sich nach der Bauhöhe einer in das Gehäuse 1 einzusetzenden Leiterplatte 6, die ihrerseits wieder elektronische Bauteile, Steckverbindungen und dergleichen trägt, die hier zur vereinfachten Darstellung nicht gezeigt sind. Beispielsweise mittig ist das Unterteil 2 (oder auch das Oberteil 3) mit einem Fixierdom 7 versehen, der in eine entsprechende Bohrung in der Leiterplatte 6 eingreifen kann, wenn diese auf das Unterteil 2 aufgesetzt wird. In Figur 1 ist schon gezeigt, dass das Unterteil 2 mit dem Oberteil 3 verbunden worden ist, wobei die äußeren Randbereiche der Leiterplatte 6 zwischen den einander zugewandten Flächen der umlaufenden Ränder 4, 5 eingeklemmt worden ist. Dadurch ergibt sich der Vorteil, dass ein beispielhaft gezeigtes und mit der Bezugsziffer 8 versehenes elektronisches Bauteil sehr nah bis an den umlaufenden Rand 5 angeordnet werden kann, so dass der mit "a" bezeichnete Abstand zwischen diesem elektronischen Bauteil 8 und dem umlaufenden Rand 5 klein gehalten werden kann. Die Mittel zum Verbinden der beiden Teile 2, 3, sind zunächst in Figur 1 nicht dargestellt, wozu bezüglich dieser Mittel auf die Figuren 2 bis 5 verwiesen wird.

Figur 2 zeigt in perspektivischer Darstellung das Unterteil 2 gemäß Figur 1, wobei hier z.B. zwei Fixierdome 7 vorhanden sind, die die einzusetzende Leiterplatte in ihrer Lage zu dem Unterteil 2 fixieren. Weiterhin ist noch eine Erhebung 9 vorhanden, die die Leiterplatte 6 in Distanz zu dem Unterteil 2 hält. Weiterhin weist das Unterteil 2 z.B. vier Rastlaschen 10 auf, die im Bereich der Längskante des Unterteiles 2 angeordnet sind. In den Bereichen, in denen sich die Rastlaschen 10 befinden, ist der umlaufende Rand 4 unterbrochen. An dieser Stelle sei erwähnt, dass das in Figur 2 in seiner Form beispielhaft dargestellte Unterteil 2 z.B. aus Kunststoff in einem Spritzgussverfahren als einteiliges Stück hergestellt werden kann.

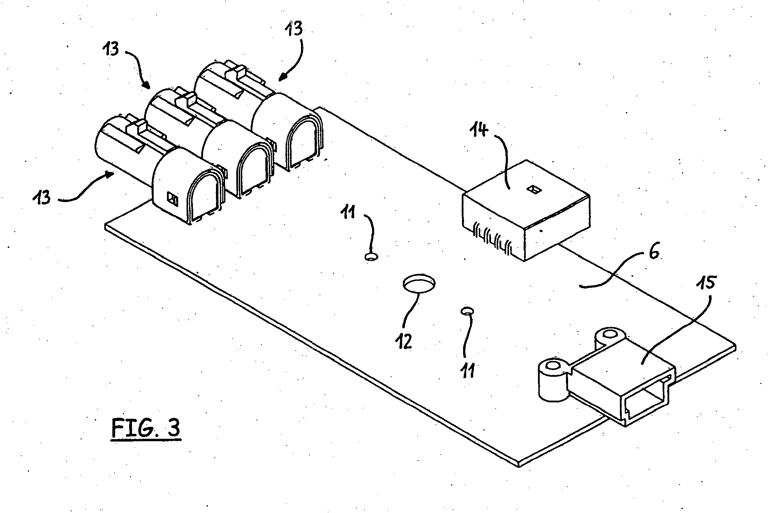

Figur 3 zeigt beispielhaft die Leiterplatte 6, die entsprechend der Lage der Fixierdome 7 korrespondierende Fixieröffnungen 11 aufweist. Zur späteren Befestigung des fertig gestellten Elektronikgerätes ist in der Leiterplatte 6 eine Befestigungsöffnung 12 im Bereich der Erhebung 9 vorgesehen. Durch diese Befestigungsöffnung 12 und die korrespondierende Öffnung im Bereich der Erhebung 9 kann z.B. eine Schraube eingesetzt werden, mit der das Elektronikgerät beispielsweise an einem Fahrzeugteil befestigt (verschraubt) werden kann. Zur Erhöhung der Stabilität ist auch deswegen die Erhebung 9 vorgesehen. Weiterhin weist die Leiterplatte 6 verschiedenartige (oder auch gleichartige) Steckverbindungen 13, 14, 15, auf, bei denen es sich um Signaleingänge, Signalausgänge und/oder Stromversorgungen handelt. Ebenso sind auf der Leiterplatte 6 elektronische Bauteile vorhanden, die allerdings in Figur 3 nicht dargestellt sind.

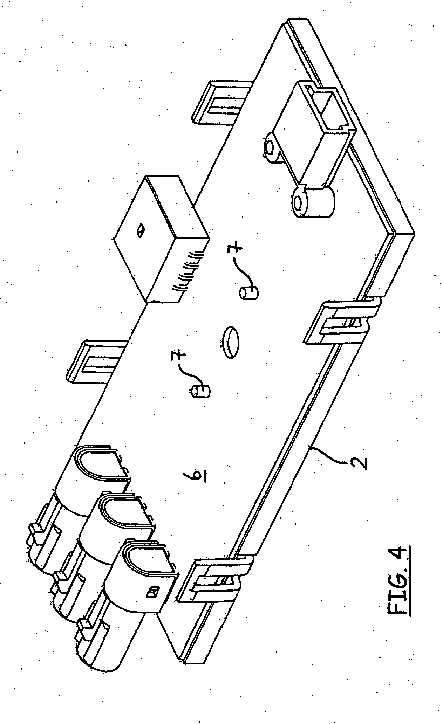

Figur 4 zeigt den nächsten Montageschritt, dass nämlich die Leiterplatte 6 in das Unterteil 2 eingelegt worden ist. Dabei treten die Fixierdome 7 durch die Fixieröffnungen 11, so dass die Leiterplatte 6 in ihrer Lage zu dem Unterteil 2 fixiert ist. Dabei ist darauf hinzuweisen, dass die Randbereiche der Leiterplatte bei dieser Ausführungsform nahezu vollständig auf dem umlaufenden Rand 4 (soweit dieser vorhanden ist) aufliegen. Dieser in Figur 4 gezeigte Montageschritt lässt sich einfach bewerkstelligen und kann manuell oder automatisiert ohne ein sonstiges Werkzeug durchgeführt werden.

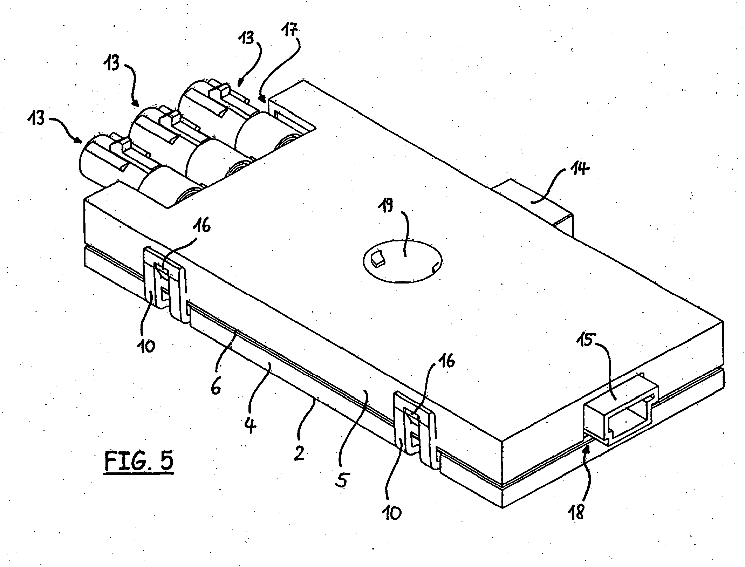

Figur 5 zeigt, dass auf das vormontierte Unterteil 2 das Oberteil 3 mittels einer Rastverbindung aufgeklipst wurde. Zu diesem Zweck weist das Oberteil 3 im Bereich der zugehörigen Rastlaschen 10 Rastnasen 16 auf, die die Rastlaschen 10 hintergreifen. Dabei sind die Rastlaschen 10 in einer Art und Weise an dem Unterteil 2 vorhanden (hier wird auf Figur 2 verwiesen), das die Rastverbindung nach dem Verklipsen unter eine Vorspannung steht. Dies bewirkt einerseits das Einklemmen der Leiterplatte 6 zwischen den umlaufenden Rändern 4, 5 von Unterteil 2 und Oberteil 3 und andererseits vor einem Schutz von Bewegungen der Leiterplatte 6 innerhalb des Gehäuses 1, so dass unerwünschte Geräuschentwicklungen vermieden werden. Außerdem tritt durch diese Klemmwirkung eine Dichtfunktion auf, die noch von einer zwischen umlaufendem Rand 4 und Leiterplatte 6 bzw. umlaufendem Rand 5 und Leiterplatte 6 einbringbaren Dichtung gesteigert werden kann. Je nach Einbausituation kann diese Dichtung entbehrlich sein, wie dies z.B. aus Figur 5 hervorgeht. Denn wenn es beabsichtigt ist, das Elektronikgerät an einem geschützten Ort anzubringen, kann z.B. das Oberteil 3 auch Aussparungen 17, 18 aufweisen, die in Lage und Größe mit den Steckverbindungen 13, 14, 15 korrespondieren.

Wenn also die Gehäuse der Steckverbindungen 13, 14, 15 auf Distanz angeordnet sind zu dem Oberteil 3 (und/oder gegebenenfalls zu dem Unterteil 2) kann einerseits eine gewisse Toleranz und andererseits eine Luftzirkulation innerhalb des Gehäuses 1 erfolgen. Mit der Bezugsziffer 19 ist noch eine Öffnung in dem Oberteil 3 bezeichnet, in der, wie schon erwähnt, eine Befestigungsschraube zur Befestigung des Gehäuses 1 an einem Fahrzeugteil (oder einem sonstigen Teil) erfolgen kann.

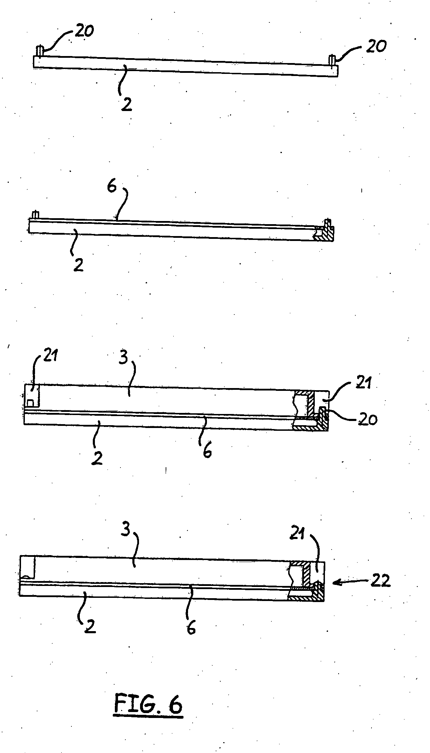

Figur 6 zeigt, ähnlich wie die Figuren 2-5, die Montagereihenfolge eines Gehäuses, wobei hier das Unterteil 2 z.B. im Randbereich (vor allen Dingen an allen vier Ecken) Zapfen 20 aufweist. Im nächsten Schritt erfolgt das Auflegen der Leiterplatte 6 auf das Unterteil 2, wobei je nach Bauweise des Unterteils 2 bzw. der Leiterplatte 6 das Unterteil 2 einen umlaufenden Rand haben kann oder nicht.

Im nächsten Schritt erfolgt das Aufsetzen des Oberteils 3 auf die Leiterplatte 6, wobei das Oberteil 3 in Figur 6 an den Ecken Aussparungen 21 aufweist, damit dort die über das Oberteil 3 hinausstehenden Zapfen 20 zugänglich sind. Zum Einklemmen der Leiterplatte 6 werden die Zapfen 20 auf geeignete Art und Weise verformt, so dass im Endbereich ein Umformbereich 22 entsteht. Durch diese Zapfen 20 (Mittel zum Verbinden der beiden Gehäuseteile 2, 3) und deren Verformung wird die Leiterplatte 6 zwischen dem Unterteil 2 und dem Oberteil 3 eingeklemmt.

Figur 7 zeigt einen Schnitt durch ein Elektronikgerät gemäß dem Stand der Technik, wobei hier erkennbar ist, dass die Leiterplatte 6 zum Toleranzausgleich in nachteiliger Weise einen Abstand "b" zu den Gehäuseteilen 2, 3 (bzw. den umlaufenden Rändern 4, 5, die auf Stoß 23 aufeinander liegen) halten muss. Aus fertigungstechnischen Gründen muss das elektronische Bauteil 8 zu dem Randbereich der Leiterplatte 6 einen Mindestabstand "c" aufweisen, so dass sich die für elektronische Bauteile zur Verfügung stehende Fläche der Leiterplatte 6 in nachteiliger Weise verkleinert.

Im Gegensatz hierzu wird mit der Erfindung erzielt, dass "a" in Figur 1 kleiner gleich "b" plus "c" in Figur 7 ist.

Alternative Gestaltungsmöglichkeiten:
a) Statt des Fixierdomes in Figur 1, der die Leiterplatte 6 nur in deren horizontalen Ebene fixiert, kann man sich auch zumindest ein weiteres oder alternatives Befestigungelement denken, dass auch in vertikaler Richtung zur Leiterplatte 6 die Leiterplatte 6 fixiert (z.B. indem man den Dom 7 verstemmt oder mit der Leiterplatte 6 verschraubt oder indem man anstatt des Domes ein Rastelement am Unterteil 2 vorsieht oder indem man die Leiterplatte 6 auf den Dom 7 über das korrespondierende Loch 11 der Leiterplatte 6 aufpresst). Damit ist dann gewährleistet, dass während des Montageprozesses die Leiterplatte 6 fest mit dem Gehäuseteil 2 fixiert ist, ohne dass das Gehäuseteil 3 schon montiert ist.
b) Die Leiterplatte 6 muss nicht umlaufend zwischen den Gehäuseteilen 2, 3 eingeklemmt werden. Sie kann auch nur partiell zwischen die Gehäuseteile 2, 3 eingeklemmt werden.
c) Das Einklemmen erfolgt in vorteilhafter Weise an den äusseren Gehäusewänden 4, 5. Es kann aber auch ein Einklemmen im Innenbereich der Leiterplatte 6 bzw. des Gehäuses 1 z.B. durch Dome oder Rippen erfolgen.
d) Die Befestigung der Gehäuseteile 2, 3 kann durch verschiene Verbindungstechniken realisiert werden: Verclipsung, Heissverstemmen, Schweissen, Nieten, Schrauben, Kleben usw.
e) Die Arretur der Leiterplatte 6 mit dem Gehäuseteil 2 über den zumindest einen Fixierdom 7 wie in Figur 1 kann auch auf anderem Weg erfolgen. Zum Beispiel durch ein Fixieren an der Gehäusewand oder anderen Bereichen des Gehäuses. Dadurch können die Fixierlöcher in der Leiterplatte entfallen.

### Zusammenfassung der Vorteile der Sandwich-Bauweise:

Die Befestigung der Leiterplatte 6 nach der in den Figuren gezeigten Sandwichbauweise bringt mehrere Vorteile mit sich:
1) Der separate Montageschritt "Befestigung Leiterplatte mit Gehäuse" kann ganz entfallen. D.h. Montageschritte wie Verstemmen, Verclipsen, Verschrauben, Vernieten usw. entfallen samt den dazugehörigen Montageeinrichtungen.
2) Die Leiterplattenfläche wird im Vergleich zu den Gehäusseaussenabmessungen besser ausgenutzt. Dadurch können kleinere Gehäuseabmessungen realisiert werden. Möglich ist dieses zum einen dadurch, dass man die Elektronikbauteile auf der Leiterplatte näher zur Gehäusewand plazieren kann. In Figur 1 ist das Elektronikbauteil mit dem Abstand "a" zur Gehäusewand plaziert. Dieser Abstand ist aus Toleranzgründen einzuhalten. In Figur 7 sieht man einen Schnitt durch ein konventionelles Elektronikgerät. Dort ist die Leiterplatte nicht in der Sandwich-Technik befestigt und weist somit einen Abstand "b" zwischen ihrer Berandung und der Gehäusewand auf. Zusätzlich zu diesem Abstand "b" muss auch noch ein Abstand "c" zwischen der Leiterplattenberandung und dem ihr nahestmöglichen Elektronikbauteil eingehalten werden. Die Summe der Abstände "b" und "c" ist auf jeden Fall größer als der alleinige Abstand "a". Zum anderen entfallen durch die Sandwich-Bauweise auf der Leiterplatte platzraubende Löcher und Schlitze für die Befestigung der Leiterplatte mit dem Gehäuse. Um die Leiterplattenfläche noch besser auszunutzen, können Leiterbahnen auch im äussersten Bereich der Leiterplatte, also zum Beispiel unter bzw. über den einklemmenden Gehäusewandungen, verlegt werden.
3) Durch die formschlüssige Einbindung der Leiterplatte in die Gehäusestruktur erhält man eine Vesteifung der Gesamtstruktur, was unter anderem der Schwingfestigkeit der Konstruktion zu Gute kommt.
4) Leiterplatte und Gehäuseteile können kostengünstiger ausgeführt werden, da toleranzkritische Konstruktionselemente wie Befestigungslöcher, -schlitze, - dome oder -clipse entfallen.
5) Dauerfestigkeit ist garantiert, da die Kontaktfläche zwischen Leiterplatte und einklemmenden Gehäusebereich relativ groß ist und damit die Flächenpressung zwischen Leiterplatte und den Gehäuseteilen klein ausfällt.
6) Reparaturfreundliche Lösung, da kein Verstemmen, Schweissen oder andere unlösbare Verbindungstechniken zum Einsatz kommen und somit die Leiterplatte im Servicefall zugänglich ist.

### Bezugszeichenliste

- 1.: Gehäuse
- 2.: Unterteil
- 3.: Oberteil
- 4.: Umlaufender Rand
- 5.: Umlaufender Rand
- 6.: Leiterplatte
- 7.: Fixierdom
- 8.: Elektronisches Bauteil
- 9.: Erhebung
- 10.: Rastlasche
- 11.: Fixieröffnung
- 12.: Befestigungsöffnung
- 13.: Steckverbindung
- 14.: Steckverbindung
- 15.: Steckverbindung
- 16.: Rastnase
- 17.: Aussparung
- 18.: Aussparung
- 19.: Öffnung
- 20.: Zapfen
- 21.: Aussparung
- 22.: Umformbereich
- 23.: Stoß

## Patentansprüche

1. Gehäuse (1) für ein Elektronikgerät, insbesondere ein Antennenverstärker eines Fahrzeuges, wobei das Gehäuse (1) zumindest eine Leiterplatte (6) mit elektronischen Bauteilen (8) aufnimmt und aus zumindest zwei Gehäuseteilen wie einem Unterteil (2) und einem Oberteil (3) besteht, wobei Mittel zum Verbinden der zumindest beiden Gehäuseteile miteinander vorhanden sind, wobei durch das Verbinden die Leiterplatte (6) in Teilbereichen von den beiden Gehäuseteilen eingeklemmt und dadurch in ihrer Lage in dem Gehäuse (1) fixiert wird, wobei die äußeren Randbereiche der Leiterplatte (6) zwischen einander zugewandten Flächen von umlaufenden Rändern (4, 5) der Gehäuseteile eingeklemmt sind und das zumindest eine elektronische Bauteil (8) sehr nah bis an den umlaufenden Rand (5) angeordnet ist, so däss ein Abstand "a" zwischen diesem elektronischen Bauteil (8) und dem umlaufenden Rand (5) klein gehalten werden kann, **dadurch gekennzeichnet, dass** das Unterteil (2) oder das Oberteil (3) mit zumindest einem Fixierdom (7) versehen ist, der in eine entsprechende Bohrung in der Leiterplatte (6) eingreifen kann, wenn diese auf das Unterteil (2) oder das Oberteil (3) aufgesetzt wird.

2. Gehäuse (1) nach Anspruch 1, **dadurch gekennzeichnet, dass** die Mittel zum Verbinden der beiden Gehäuseteile als Rastmittel (10, 16) ausgebildet sind.

3. Gehäuse (1) nach Anspruch 2, **dadurch gekennzeichnet, dass** die Mittel zum Verbinden der beiden Gehäuseteile nach dem Verbinden unter Vorspannung stehen.

4. Gehäuse (1) nach einem der Ansprüche 1 bis 3, **dadurch gekennzeichnet, dass** die Mittel zum Verbinden der beiden Gehäuseteile zur Lagefixierung der Leiterplatte (6) in Bezug auf zumindest ein Gehäuseteil (2, 3) ausgebildet sind.

5. Gehäuse (1) nach einem der vorhergehenden Ansprüche, **dadurch gekennzeichnet, dass** zumindest eines der beiden Gehäuseteilen (2, 3) zumindest eine Aussparung (17, 18), zur Aufnahme der wenigstens einen Steckverbindung (13, 14, 15) aufweist.

6. Gehäuse (1) nach Anspruch 5, **dadurch gekennzeichnet, dass** die zumindest eine umlaufende Aussparung (17, 18) in dem zumindest einen umlaufenden Rand (4, 5) angeordnet ist.

7. Gehäuse (1) nach einem der vorhergehenden Ansprüche, **dadurch gekennzeichnet, dass** die zumindest beiden Gehäuseteile (2, 3) lösbar oder unlösbar miteinander verbunden werden, nachdem zwischen ihnen die Leiterplatte (6) eingeklemmt wurde.

8. Gehäuse (1) nach einem der vorhergehenden Ansprüche, **dadurch gekennzeichnet, dass** das Unterteil (2) und das Oberteil (3) gelenkig, insbesondere über ein Filmscharnier, miteinander verbunden sind.

9. Gehäuse (1) nach Anspruch 1, **dadurch gekennzeichnet, dass** sich auf der Leiterplatte (6) mindestens eine Steckverbindung (13,14,15) befindet.

10. Gehäuse (1) nach Anspruch 1, **dadurch gekennzeichnet, dass** das Einklemmen der Leiterplatte (6) in inneren Teilbereichen der Leiterplatte (6) erfolgt und die einklemmenden Bereiche der beiden Gehäuseteile (2,3) durch Gehäusewände, Rippen oder Stege realisiert sind.

11. Gehäuse (1) nach einem der vorhergehenden Ansprüche, **dadurch gekennzeichnet, dass** die Mittel zum Verbinden der beiden Gehäuseteile (2,3) durch Verstemmen, Ultraschallschweissen, Verschrauben, Vernieten oder Verkleben realisiert sind.

## Claims

1. Housing (1) for an electronics device, in particular an antenna amplifier of a vehicle, wherein the housing (1) accommodates at least one printed circuit board (6) with electronic components (8) and comprises at least two housing parts, such as a lower part (2) and an upper part (3), wherein means for connecting the at least two housing parts to one another are provided, wherein, by virtue of the connection operation, the printed circuit board (6) is clamped into subregions of the two housing parts and as a result is fixed in position in the housing (1), wherein the outer edge regions of the printed circuit board (6) are clamped in between facing surfaces of circumferential edges (4, 5) of the housing parts, and the at least one electronic component (8) is arranged very close to the circumferential edge (5), so that a distance "a" between this electronic component (8) and the circumferential edge (5) can be kept small, **characterized in that** the lower part (2) or the upper part (3) is provided with at least one fixing stem (7) which can engage into a corresponding hole in the printed circuit board (6) when said printed circuit board is mounted onto the lower part (2) or the upper part (3).

2. Housing (1) according to Claim 1, **characterized in that** the means for connecting the two housing parts are in the form of latching means (10, 16).

3. Housing (1) according to Claim 2, **characterized in that** the means for connecting the two housing parts are under prestress after the connection operation.

4. Housing (1) according to one of Claims 1 to 3, **characterized in that** the means for connecting the two housing parts are designed to fix the printed circuit board (6) in position in relation to at least one housing part (2, 3).

5. Housing (1) according to one of the preceding claims, **characterized in that** at least one of the two housing parts (2, 3) has at least one cutout (17, 18) for accommodating the at least one plug connection (13, 14, 15).

6. Housing (1) according to Claim 5, **characterized in that** the at least one circumferential cutout (17, 18) is arranged in the at least one circumferential edge (4, 5).

7. Housing (1) according to one of the preceding claims, **characterized in that** the at least two housing parts (2, 3) are connected to one another in a detachable or non-detachable manner after the printed circuit board (6) has been clamped in between them.

8. Housing (1) according to one of the preceding claims, **characterized in that** the lower part (2) and the upper part (3) are connected to one another in an articulated manner, in particular by means of a film hinge.

9. Housing (1) according to Claim 1, **characterized in that** at least one plug connection (13, 14, 15) is located on the printed circuit board (6).

10. Housing (1) according to Claim 1, **characterized in that** the printed circuit board (6) is clamped into inner subregions of the printed circuit board (6), and the clamping-in regions of the two housing parts (2, 3) are realized by housing walls, ribs or webs.

11. Housing (1) according to one of the preceding claims, **characterized in that** the means for connecting the two housing parts (2, 3) are realized by caulking, ultrasonic welding, screwing, riveting or adhesive bonding.

## Revendications

1. Boîtier (1) pour un appareil électronique, notamment un amplificateur d'antenne d'un véhicule, le boîtier (1) logeant au moins une plaque conductrice (6) avec des composants électroniques (8) et se composant d'au moins deux parties de boîtier telles qu'une partie inférieure (2) et une partie supérieure (3), des moyens de liaison entre elles des au moins deux parties de boîtier étant présents, la plaque conductrice (6) étant enserrée par la liaison dans les zones partielles des deux parties de boîtier et ainsi fixée dans sa position dans le boîtier (1), les zones de bordure extérieures de la plaque conductrice (6) étant enserrées entre les surfaces orientées l'une vers l'autre des bordures (4, 5) périphériques des parties de boîtier et l'au moins un composant électronique (8) étant disposé très proche de la bordure (5) périphérique, de sorte qu'une distance « a » entre ce composant électronique (8) et la bordure (5) périphérique peut être maintenue petite, **caractérisé en ce que** la partie inférieure (2) ou la partie supérieure (3) est pourvue d'au moins un dôme de fixation (7) pouvant s'imbriquer dans un alésage correspondant prévu dans la plaque conductrice (6) lorsque celle-ci est placée sur la partie inférieure (2) ou la partie supérieure (3).

2. Boîtier (1) selon la revendication 1, **caractérisé en ce que** les moyens de liaison des deux parties de boîtier prennent la forme de moyens d'encliquetage (10, 16).

3. Boîtier (1) selon la revendication 2, **caractérisé en ce que** les moyens de liaison des deux parties de boîtier sont sous précontrainte une fois la liaison effectuée.

4. Boîtier (1) selon l'une quelconque des revendications 1 à 3, **caractérisé en ce que** les moyens de liaison des deux parties de boîtier sont réalisées pour fixer la position de la plaque conductrice (6) par rapport à au moins une partie de boîtier (2, 3).

5. Boîtier (1) selon l'une quelconque des revendications précédentes, **caractérisé en ce qu'**au moins une des deux parties de boîtier (2, 3) comporte au moins un évidement (17, 18) permettant de recevoir l'au moins une liaison par enfichage (13, 14, 15).

6. Boîtier (1) selon la revendication 5, **caractérisé en ce que** l'au moins un évidement (17, 18) périphérique est disposé dans l'au moins une bordure (4, 5) périphérique.

7. Boîtier (1) selon l'une quelconque des revendications précédentes, **caractérisé en ce que** les au moins deux parties de boîtier (2, 3) sont reliées entre elles de façon amovible ou inamovible une fois la plaque conductrice (6) enserrée entre elles.

8. Boîtier (1) selon l'une quelconque des revendications précédentes, **caractérisé en ce que** la partie inférieure (2) et la partie supérieure (3) sont reliées entre elles de façon articulée, notamment via une charnière à film.

9. Boîtier (1) selon la revendication 1, **caractérisé en ce qu'**au moins une liaison par enfichage (13, 14, 15) se trouve sur la plaque conductrice (6).

10. Boîtier (1) selon la revendication 1, **caractérisé en ce que** l'enserrage de la plaque conductrice (6) se produit dans les zones partielles intérieures de la plaque conductrice (6) et que les zones enserrées des deux parties de boîtier (2, 3) sont réalisées par le biais des parois de boîtier, de nervures ou d'étais.

11. Boîtier (1) selon l'une quelconque des revendications précédentes, **caractérisé en ce que** les moyens de liaison des deux parties de boîtier (2, 3) sont réalisées par matage, soudure aux ultrasons, vissage, rivetage ou collage.
